# EUROPEAN PATENT SPECIFICATION

(11) **EP 0 425 859 B1**
(45) Date of publication and mention of the grant of the patent: **13.09.1995**
(21) Application number: 90119540.4
(22) Date of filing: 11.10.1990
(51) Int. Cl.: G01R 13/34, H01L 29/88

(54) **Sampling head**
Abtastkopf
Tête d'échantillonnage

(30) Priority: 31.10.1989 JP 284511/89
(43) Date of publication of application: 08.05.1991
(73) Proprietor: Yokogawa Electric Corporation, Tokyo 180 (JP)
(72) Inventor: Uchida, Satoru, c/o Yokogawa Electric Corp., Musashino-shi, Tokyo 180 (JP); Miura, Akira, c/o Yokogawa Electric Corp., Musashino-shi, Tokyo 180 (JP); Yakihara, Tsuyoshi c/o Yokogawa Electric Corp., Musashino-shi, Tokyo 180 (JP); Kobayashi, Shinji c/o Yokogawa Electric Corp., Musashino-shi, Tokyo 180 (JP); Oka, Sadaharu c/o Yokogawa Electric Corp., Musashino-shi, Tokyo 180 (JP); Kamata, Hiromi c/o Yokogawa Electric Corp., Musashino-shi, Tokyo 180 (JP)
(74) Representative: Henkel, Feiler, Hänzel & Partner

(56) References cited:
- EP-A- 0 336 470
- US-A- 3 629 731
- I.B.M. T.D.B. vol. 18, no. 7, December 1975, PALO ALTO CA U.S. pages 2352 - 2353; ELLIOTT: 'Analogue , time-drift control circuit for sampling oscilloscopes'
- HEWLETT-PACKARD vol. 38, no. 7, July 1987, PALO ALTO CA U.S. pages 4 - 13; HAWORTH ET AL.: 'Dedicated display monitors digital patterns'
- 1990 IEEE MTT-S INT. MICROWAVE SYMP. DIGEST vol. II, 8 May 1990, DALLAS TEXAS U.S. pages 845 - 848; MUIRA: 'FULL MONOLITHIC SAMPLING HEAD IC'
- I.B.M. T.D.B. vol. 18, no. 7, December 1975, PALO ALTO CA U.S. pages 2354 - 2355; ELLIOT: 'Accurately observing the signals from repetitive, triggerable sources in the low-microvolt, low picosecond range.'
- Appl. Phys. Lett., Vol. 54, 9 January 1989, pages 153 - 155

## Description

### BACKGROUND OF THE INVENTION.

### Field of Invention.

This invention relates to a sampling head provided in such a high-frequency device as a sampling oscilloscope; and more particularly, to a sampling head in which both high speed measurement and miniaturization are attained.

### Description of the Prior Art.

The sampling head, such as disclosed in US-A-3,629,731, is used in a sampler which functions to gather a measured high-frequency signal at a predetermined cycle and to re-synthesize the gathered data with a low frequency.

The sampling head used for the sampler is an important device element for the high frequency device such as a network analyzer or a waveform analyzer.

In the sampling head, measurement frequency band is determined by a gate time of a diode bridge included therein. In order to gate the diode bridge, an impulse so called a strobe pulse is used. In the conventional apparatus, a step recovery diode (SRD) is used for a high frequency strobe pulse generator, and moreover, GaAs Schottky barrier diodes (SBD) are used for the diode bridge. A strobe command pulse used for gating the diode bridge is produced with an outside device, and applied to the diode bridge through bonding.

The above discussed conventional device has many problems as follows:
1. The upper limit of the sampling frequency is determined by the pulse width of the strobe pulse. However, when the above SRD is used for the strobe pulse generator, the pulse width can not be made less than 30ps, and thus, the frequency band is limited.
2. Since the SRD involves a lot of jitters, time resolution is not improved.
3. Moreover, a large power( - 100Vpp. more or less 1 A; Vpp = Voltage peak-to-peak ) is necessary to drive the SRD, and the output pulse include a lot of noise components.
4. In case of the GaAs Schottky barrier diode used for the diode bridge, the characteristic (ON voltage V_{F}) is not controlled, and thus, desired performance is not obtained.
5. Further, the strobe pulse used for gating the diode bridge is applied from the outside device through bonding, and therefore, the frequency band is limited by the loss at a connecting part.

From prior art document Appl. Phys. Lett. Vol. 54, 9 January 1989, pages 153-155, it is known that with maximum frequency of oscillation in the millimeter-wave range, resonant tunneling diodes (RTDs) have been extensively studied for their potential as oscillators and mixers, and that their application to high-speed switching and pulse forming has also been examined. According to an accurate and physical equivalent circuit model of the RTD, the importance of the peak-to-valley ratio diminishes above 2:1 and the current density and device capacitance are more suitable figures of merit.

### SUMMARY OF THE INVENTION.

An object of the invention is to provide a sampling head having a wide frequency band, a wide dynamic range, and low noise and low jitter characteristic, and whose size can be miniaturized.

To solve this object the present invention provides a sampling head as specified in claim 1.

In this sampling head a resonance tunnel barrier diode (RTD) is used as a strobe pulse generator.

### BRIEF DESCRIPTION OF THE DRAWINGS.

Fig. 1 is a structural diagram depicting one example of a strobe pulse generating means of the invention.

Fig. 2 is a diagram depicting a functional conceptualization of RTD.

Fig. 3 is a diagram depicting the energy band of RTD.

Fig. 4 is a circuit diagram depicting the sampling head of the invention.

Fig. 5 is a diagram depicting one example of cross wiring.

Fig. 6(a) is a diagram depicting the cross section of RTD and Schottky barrier diode (SBD).

Fig. 6(b) is a table showing the layer thickness of RTD and SBD.

Figs. 7(a) and 7(b) are diagrams depicting the conceptualization of an electric field applied to the barrier of RTD.

Fig. 8 is a diagram depicting the I-V characteristic of RTD.

Figs. 9(a) to 9(f) are diagrams depicting the characteristics of the Schottky diode, in which Figs. 9(a) to 9(c) depict the forward direction characteristic thereof and Figs. 9(d) to 9(f) depict the reverse direction characteristic thereof.

Figs. 10(a) to 10(d) are schematic diagrams depicting the manufacturing process of RTD and the Schottky diode made on the same substrate.

Fig. 11 is a circuit diagram depicting such an example that RTD is used for a pulse generator.

Figs. 12(a) to 12(c) are characteristic curves for explaining the amplitude of RTD.

Fig. 13 is a diagram depicting a circuit in which a transformer is provided behind RTD in the sampling head shown in Fig. 3.

### DETAILED DESCRIPTION OF PREFERRED EMBODIMENTS.

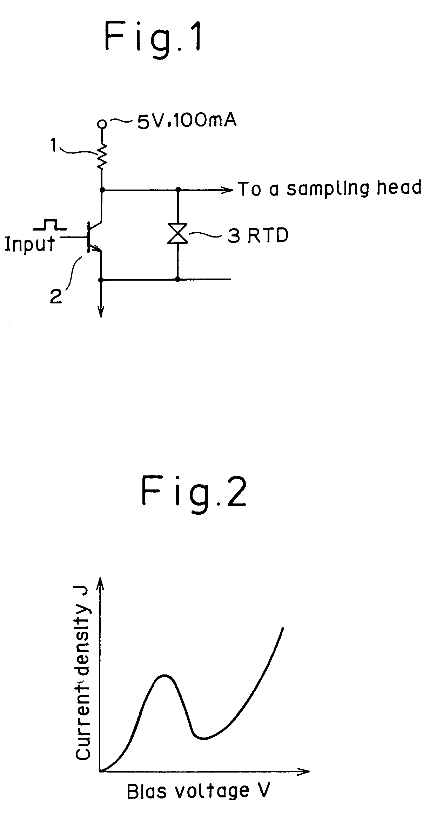

Fig. 1 depicts one example of a strobe pulse generating means, wherein one end of a resistor 1 is connected to a collector of a transistor 2 whose emitter is connected to common, and RTD 3 is connected between the collector and the emitter of transistor 2.

In the conventional apparatus, SRD was connected between the collector and the emitter of transistor 2. This invention is different from the conventional apparatus in that RTD is used in place of the step recovery diode (SRD). Moreover, this invention is different from the conventional apparatus in that a pulse voltage signal having 5Vpp and 100mA is used as the drive signal of SRD. In the conventional apparatus which uses SRD, this drive signal was about 100Vpp and 1A.

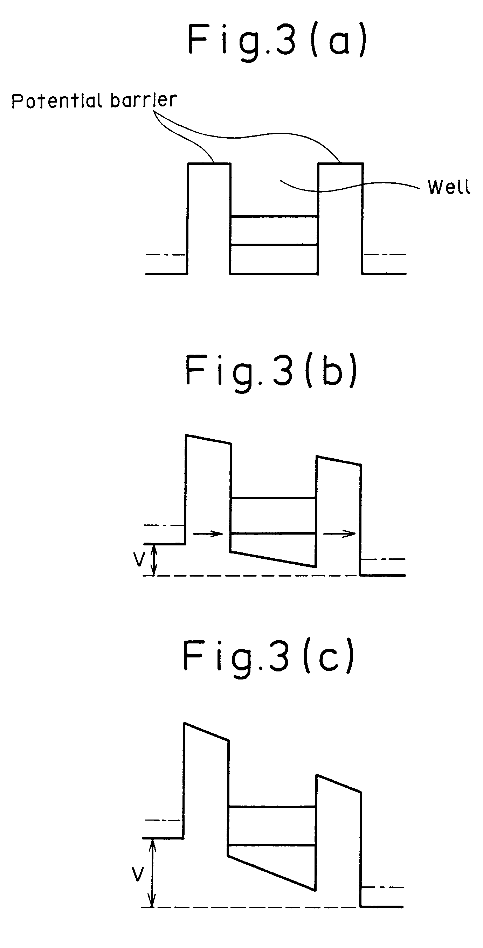

The function of RTD will be explained in accordance with Fig. 2 and Figs. 3(a) to 3(c). Fig. 2 depicts the functional conceptualization of RTD, in which the relation between the bias voltage and the current density is depicted.

The structure of RTD is constituted by 2 potential barrier layers and a well (quantum well) which is sandwiched between these potential barrier layers.

The layer structure is one-dimensional well type potential structure, and in the well layer, the quantum mechanics discrete levels are generated.

When the voltage is applied to both ends of this RTD, and when the electronic energy on cathode side coincides with one of levels of the well, the current having such negative resistance characteristic shown in Fig. 2, flows.

Switching speed of RTD is extremely high, and therefore, RTD can oscillate at a high frequency more than 200 GHz.

Moreover, the jitter which occurs in RTD is fewer than that of SRD, and therefore, the time resolution is improved.

Furthermore, a large and high speed power pulse transformer is unnecessary for driving SRD.

By the way, an Esaki diode (tunnel diode) is well known as a negative resistance device. However, structurally, it is impossible to reduce the volume of capacitance because of its p⁺⁺n⁺⁺ junction. As a result, the Esaki diode has such a drawback that charging time constant becomes large. In contrast, in case of RTD, the volume of capacitance can be reduced by about 1/100 of the Esaki diode.

Further, in the Esaki diode, the amplitude is limited by the component material, and therefore, it is impossible to change the amplitude even if necessary.

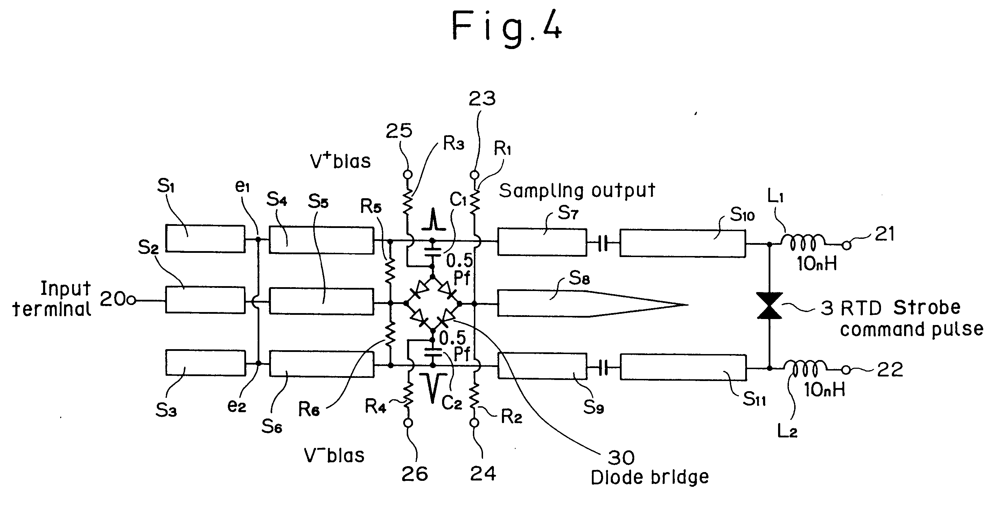

Fig. 4 depicts the circuit configuration of the sampling head. Diode bridge 30, RTD 3, resistors R₁ - R₆ and capacitors C₁ and C₂ are formed on an InP substrate by monolithic manner. Portions S₁ to S₁₁ are formed by use of conductive thin films such as gold. Of these conductive films, S₁ and S₃ are connected commonly. The width of conductive films S₂, S₅ and S₈ are formed to be about 1/10 of that of other thin films.

In this figure, the high frequency signal is inputted to an input terminal 20, and applied to diode bridge 30 through thin films S₂ and S₅.

On the other hand, a strobe command pulse is applied to terminals 21 and 22. This pulse is applied to RTD 3 connected in parallel to coils L₁ and L₂ (about 10nH), which composes a strobe pulse generator. A strobe pulse generated from RTD 3 passes thin films S₁₀ and S₇ and also thin films S₁₁ and S₉, and is applied to diode bridge 30 through small capacitors C₁ and C₂(0.5pF). The strobe pulse causes diode bridge 30 to be conductive.

The strobe pulse advances further and reflects reversely at short circuit ends e₁ and e₂ of thin films S₄ and S₆. As a result, diode bridge 30 is made to be non-conductive by the reflected strobe pulse. The gate time period when diode bridge 30 is made to be conductive, corresponds to a time when the strobe pulse shuttles between the distance from diode bridge 30 to the short circuit end of thin film S₄ or S₆.

Sampling signal obtained in the above gate period is held by thin film S₈ which composes a capacitor, and is outputted from output terminals 23 and 24 through resistors R₁ and R₂. Coils L₁ and L₂ function to stabilize the current.

From terminals 25 and 26, the bias voltage is applied to diode bridge 30 through resistors R₃ and R₄, by which diode bridge is held non-conductive state unless the strobe pulse is applied.

By these configuration, a transmission line of the input high frequency signal, constituted by thin films S₂ and S₅, is surrounded by thin films S₁, S₄, S₃ and S₆, and further, thin film S₈ is surrounded by thin films S₇ and S₉. These portions compose a coplanar wave guide (CPW). Further, thin films S10, S₇ and S₄, and thin films S₁₁, S₉, and S₆ can be regarded as coplanar stripping lines (CPS).

And, each width of thin films S₂, S₅ S₈ and is made to be about 1/10 of other thin films, and therefor, mismatching of the coplanar stripping line at thin film portion S₈ can be neglected practically. As a result, impedance mismatching does not occur between the coplanar wave guide and the coplanar stripping lines, and therefore, high frequency signal can pass these parts without loss.

In this embodiment, resistors R₅ and R₆ of 100 ohms are provided in parallel, thereby to form a terminal resistor of 50 ohms. Both the coplanar wave guide and the coplanar stripping lines are matched with 50 ohm impedance system.

In the above mentioned sampling head, bias supply wirings to diode bridge 30 and sample signal output wirings intersect the coplanar wave guide and the coplanar stripping lines where impedance matching has been treated. In this case, mismatching occurs as to the line capacitances and therefore, it is necessary to reduce the amount of this capacitance. For this purpose, an air bridge was conventionally used as the cross wiring. However, this type cross wiring has such problems that there exists limitation in making minute patterns, or that it has problems in strength.

In this invention, polyimide resin is used as an insulating film, which has small dielectric constant in comparison with SiO₂ or Si₃N₄. The line capacitance can be disregarded if the thickness of the polyimide resin is made about 5 microns. However, it is difficult to form such a polyimide resin layer by one time. Accordingly, in this invention, the polyimide layer is formed as two layer structure.

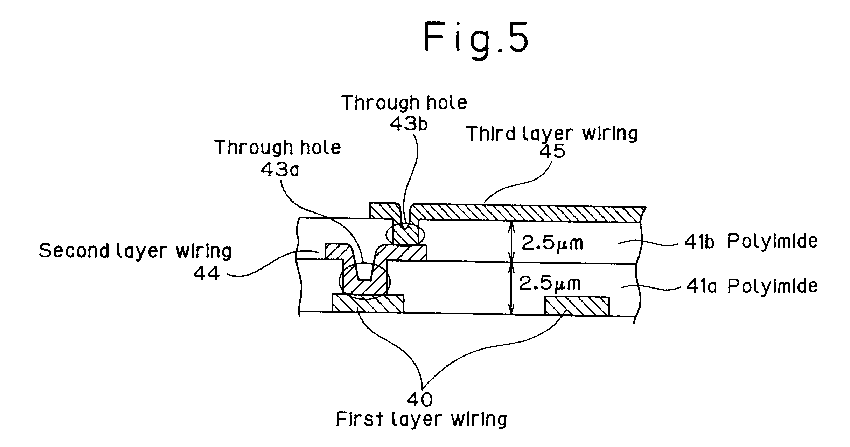

Fig. 5 shows a cross sectional view of one example of the cross wiring. Namely, a polyimide resin 41a having about 2.5 microns in thickness is deposited upon a first wiring layer 40 (lead for the coplanar wave guide or the cross wiring), and is baked, in N₂ atmosphere, at about 300 degrees C. Then, a through hole 43a is formed at places where the wirings cross, and a second layer wiring 44 is formed Upon this, a polyimide resin layer 41b of 2.5 microns in thickness is deposited and then baking is carried out.

Next, a through hole 43b which reaches the top of second wiring 44 is formed, and a third layer wiring 45 crossing the first layer wiring is formed.

By this wiring arrangement, the line capacitance between first layer wiring and the third layer wiring can be made equivalent as in case of the air bridge. As a result, it is possible to miniaturize the wirings.

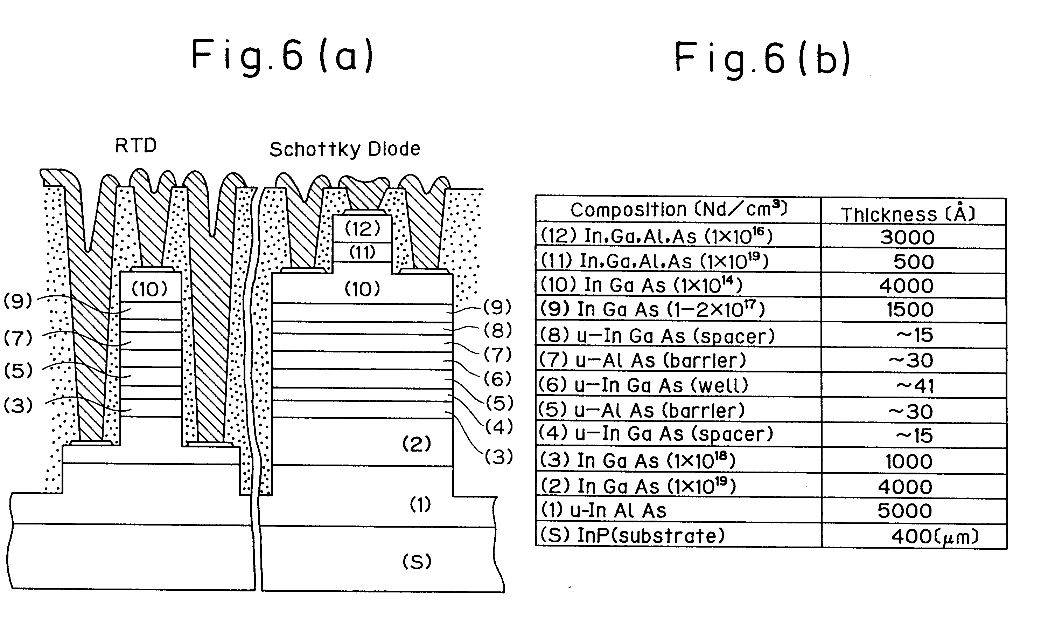

Fig. 6(a) is a diagram depicting the cross sectional view of RTD and a Schottky diode constituted by a four element mixed crystal of InGaAlAs. Fig. 6(b) is a table depicting the layer thickness of RTD and the Schottky diode made of the four element mixed crystal.

In Figs. 6(a) and 6(b), layers (5), (6) and (7) compose resonance layers of RTD. That is, InGaAs layer (6) having 41 angstroms in thickness is sandwiched by AlAs layers (5) and (7), each having 30 angstroms in thickness, by which a distortion super lattice is formed.

By the distortion super lattice, band discontinuity of the conductor becomes large. Therefore, leakage current under a room temperature can be reduced, and peak-to-valley ratio can be enlarged.

In the conventional apparatus, the resonance layer was formed in such a way that a GaAs layer having 50 angstroms in thickness was sandwiched by AlGaAs layers of 50 angstroms in thickness.

Further, in the conventional apparatus, a voltage signal having an amplitude more than 0.8 volts which is twice as much as ON voltage of the Schottky diode, is necessary to drive the diode bridge.

In this invention, in order to obtain a large amplitude output, the impurity concentration of n type InGaAs layer (9) formed on the positive pole side of RTD is reduced by about 1 - 2*10¹⁷ cm⁻³, and is made asymmetrical with respect to the impurity concentration of n type InGaAs layer (3) which functions as a negative pole.

The increase of this amplitude depends upon such a reason that the depletion layer extending to the InGaAs layer formed on the positive pole side of the resonance depletion layer, expands by reducing the impurity concentration.

By reducing the impurity concentration, a parasitic capacitance can be also reduced. Therefore, both speed up and increase of the amplitude can be accomplished at the same time.

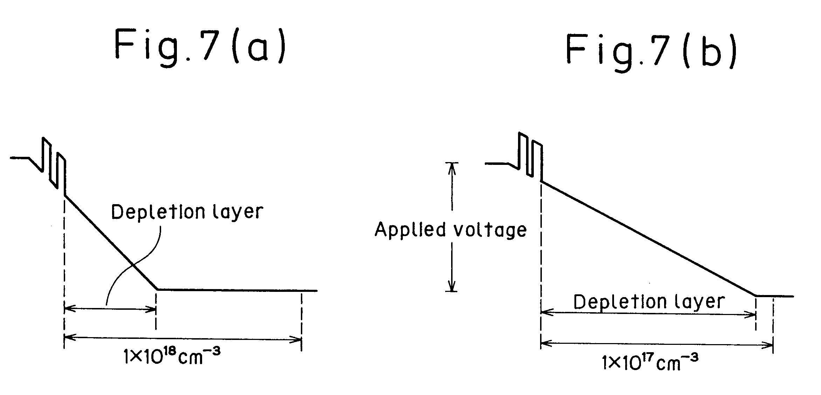

Figs. 7(a) and 7(b) are diagrams depicting an electric field applied to the depletion layer of RTD. Fig. 7(a) depicts symmetrical type conceptualization and Fig. 7(b) depicts asymmetrical type conceptualization. As understood from these figures, even if the same voltage is applied, the voltage which exerts influence upon the barrier is different between two cases, that is, when the depletion layer is thin, the above voltage becomes large, in contrast to this, when the depletion layer is thick, the above voltage becomes small.

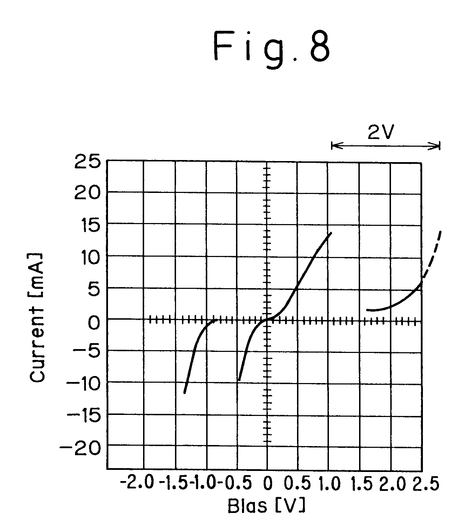

Fig. 8 is a diagram depicting the I-V characteristic of RTD. In this RTD, the impurity concentration on the positive pole side is made to be 1*10¹⁷ cm⁻³, and a positive voltage is applied to the positive pole side. As a result, the amplitude of about 2 volts can be obtained as shown by this figure.

In Fig. 6, layers (11) and (12) which compose the Schottky barrier diode (SBD) together with layer (12), are made of the four element mixed crystal of InGaAlAs. If the component of this InGaAlAs is changed in such a way as (InGaAs)ₓ(InAlAs)₁₋ₓ where x is the value changing from 0 to 1, the ON voltage V_{F} of the diode is changeable from 0.15V to 0.8V.

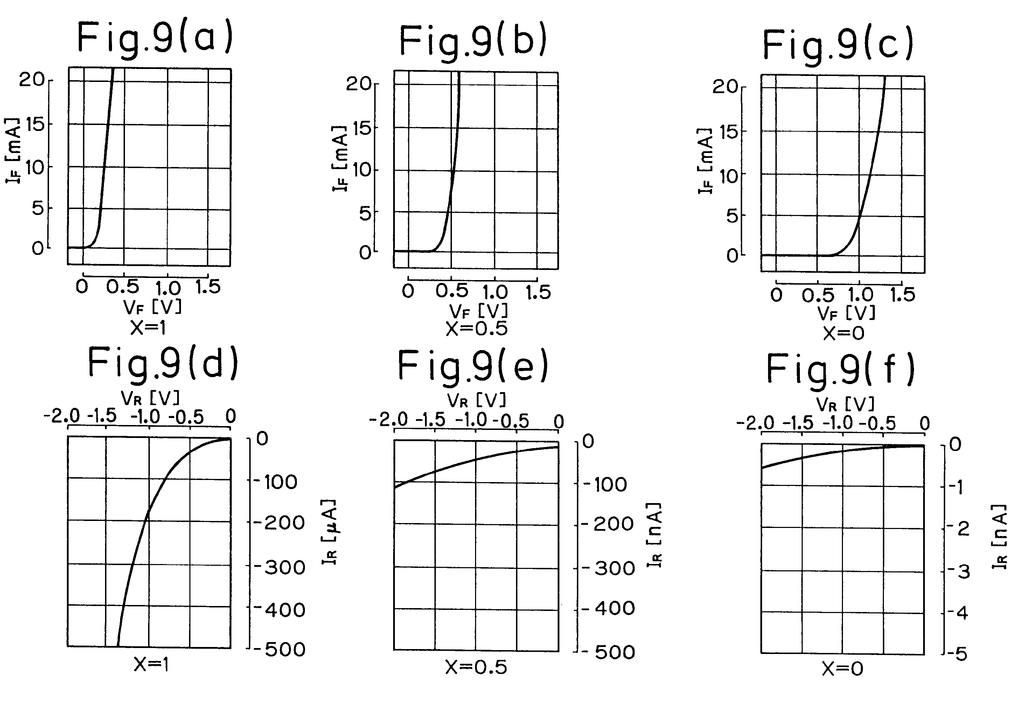

Figs. 9(a) to 9(f) are diagrams depicting the characteristic of the Schottky diode, in which Figs. 9(a) to Figs. 9(c) depict the forward direction I-V characteristic curves and Figs. 9(d) to 9(f) depict the reverse direction I-V characteristic curves. In this example, the mixture ratio x is changed in such a way as x=1, x=0.5, and x=0. From these data, it is understood that the ON voltage of the diode can be controlled between 0.15V and 0.8V, and further, is understood that trade-off exists between the ON voltage and the leak current.

Next, method for forming the diode bridge and RTD on the same substrate will be explained. As aforementioned, it is disadvantageous to arrange the diode bridge and the strobe pulse generator separately. Then, we have noticed that both the four element mixed crystal Schottky diode made of InGaAlAs and the asymmetrical doping RTD can be lattice-matched with InP substrate. Based upon this, the diode bridge and RTD are formed on the same substrate in this invention.

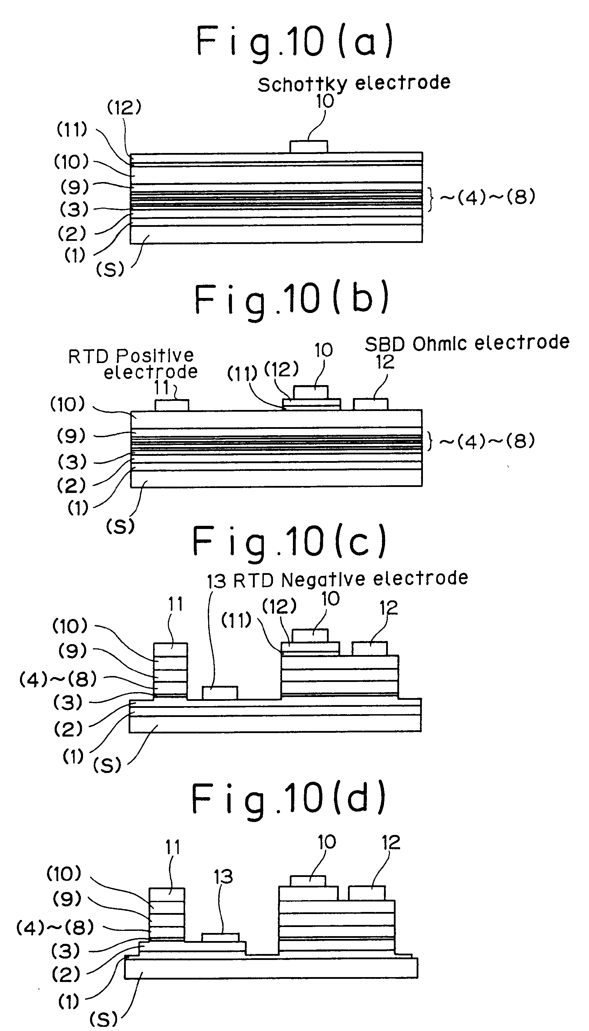

In accordance with Figs. 10(a) and 10(d), the manufacturing method will be explained in the following.

### Process a (Fig. 10(a)):

Upon an InP substrate (S) having thickness of about 400 microns, an undoped InAlAs layer (1) having thickness of about 5000 angstroms is formed.

Next, an n⁺InGaAs layer (2) of which impurity concentration is 1*10¹⁹cm⁻³ and which has thickness of 4000 angstroms, is formed upon layer (1).

Next, an n⁺InGaAs layer (3) of which impurity concentration is 1*10¹⁸cm⁻³ and which has thickness of 1000 angstroms, is formed upon layer (2).

Next, an undoped InGaAs layer (4) having thickness less than 15 angstroms is formed, and then an undoped AlAs layer (5) having thickness of 30 angstroms, an undoped InGaAS layer (6) having thickness of 41 angstroms, an undoped AlAs layer (7) having thickness less than 30 angstroms and an undoped InGaAs layer (8) having thickness less than 15 angstroms are formed.

Next, an n⁺InGaAs layer (9) of which impurity concentration is 1*10¹⁷cm⁻³ and which has thickness of 1500 angstroms, and an n InGaAs layer (10) of which impurity concentration is 1*10¹⁴cm⁻³ and which has thickness of 4000 angstroms are formed.

Next, a layer (11) of n⁺(InGaAs)_{0.5}(InAlAs)_{0.5}, of which impurity concentration is 1*10¹⁹cm⁻³ and which has thickness of 500 angstroms, is formed upon layer (10).

Next, a layer (12) of n⁻(InGaAs)_{0.5}(InAlAs)_{0.5}, of which impurity concentration is 1*10¹⁶cm⁻³ and which has thickness of 3000 angstroms, is formed upon layer (11).

These layers are formed by use of such a device as a molecular beam epitaxial device (MBE).

Then, a Schottky electrode 10 is formed by making electrode pattern films in such order as Pt/W/WSi₂/Au upon the above layer.

### Process b (Fig. 10(b)):

After protecting the surface of electrode 10 with a regist film, layers (12) and (11) are removed by etching with such a solution as citric acid plus H₂O₂, so as to expose the surface of InGaAs layer (10) where the positive pole of RTD is formed.

Next, on the surface of InGaAs layer (10), the film is formed in such order as WSi₂/Au by use of lift-off method, and patterning is applied. As the result, RTD positive electrode 11 and ohmic electrode 12 of the Schottky barrier diodes (SBD) are formed.

### Process c (Fig. 10(c)):

After protecting the surface of SBD ohmic electrode with a regist film and after masking the surface of RTD positive electrode, etching is applied by use of citric acid plus H₂O₂ solution.

As a result, InGaAs layer (2) is exposed, and a film layer is formed in such order as WSi₂/Au on the surface of layer (2). Then, patterning is applied and RTD negative pole electrode 13 is formed.

### Process d (Fig. 10(d)):

The Schottky diode and RTD portions are protected by a regist film. Then, etching is applied to InAlAs layer (1) which composes a buffer layer, by use of citric acid plus H₂O₂ solution.

By the above processing, RTD and SBD are formed on the same substrate.

In the following, the reasons why RTD can be driven by such a pulse that it has sufficiently short time width in comparison with the time until avalanche breakdown occurs, will be explained.

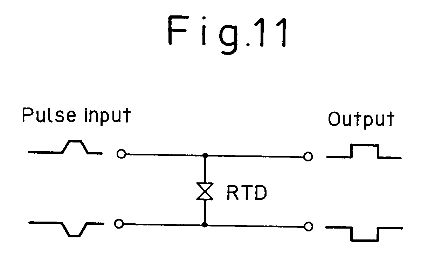

When RTD is used as a pulse generator, such a circuit as shown in Fig. 11 is used. In this circuit, both a large amplitude and a large current density are required. RTD operates, for example, at the ON-OFF duty ratio of 50% and at a frequency of several MHz. Under these conditions, coexistence of the large amplitude and the large current density is difficult by such a reason that RTD is destroyed by an avalanche breakdown which occurs in the depletion-layer.

Therefore, in the conventional apparatus using RTD as the pulse generator, there was a limitation in satisfying both requirements for the large amplitude and the large current density simultaneously.

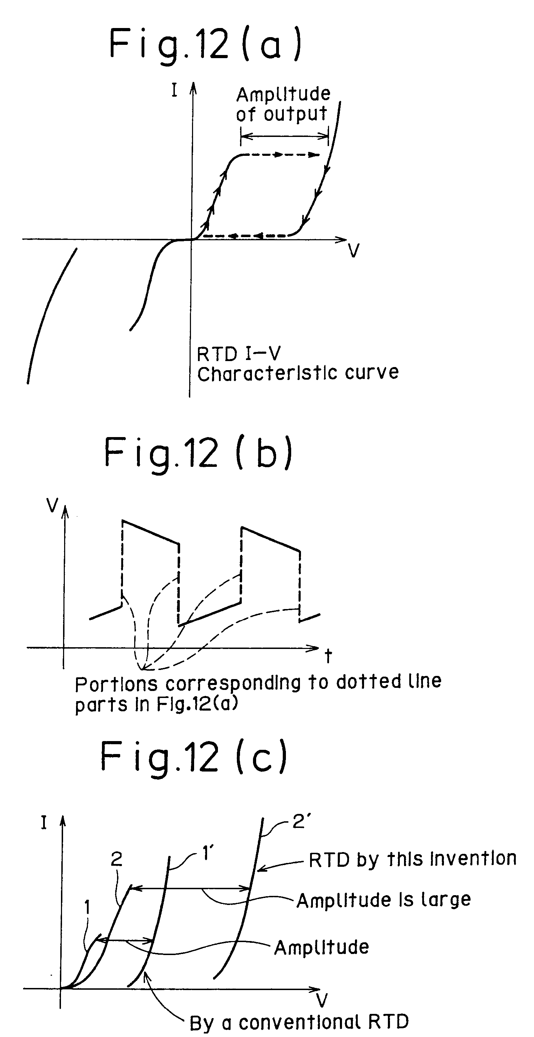

Figs. 12(a) to 12(c) are diagrams depicting current-voltage characteristic curves for explaining the amplitude of RTD.

When a pulse input is applied to RTD, such a I-V characteristic as shown by arrows in Fig. 12(a) is obtained and the output voltage as shown in Fig. 12(b) is obtained. The output rises sharply at its edge portion as shown by dotted lines in Fig. 12(b). Further, as shown in Fig. 12(c), the output has a large amplitude (2 to 2′) in comparison with the output of the conventional apparatus, which has an amplitude (1 to 1′).

The characteristic of RTD shown by 2-2′ in Fig. 12(c) is changed by controlling the impurity concentration of the semiconductor on both sides of the resonance barrier part.

The destruction of RTD can be avoided if RTD is driven with a pulse having short time width in comparison with the time until the avalanche breakdown occurs. Namely, the large amplitude and large current density can be attained, if RTD can be driven by a pulse with short time width.

In this invention, both the large amplitude and the large current density are attained by using such a drive pulse for RTD as one having a frequency of 10MHz (=100ns) and having pulse width of 5ns (ON-OFF duty ratio: about 5%).

As explained in Figs. 6(a) and 6(b), in this invention, the impurity concentration of n type InGaAs layer (9) formed on the positive pole side of RTD is reduced by about 1 - 2*10¹⁷cm⁻³, and is made asymmetrical with respect to the impurity concentration of n type InGaAs layer (3) which functions as the negative pole.

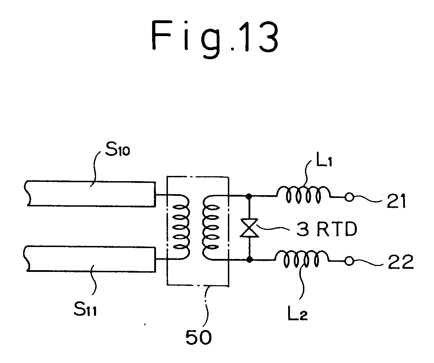

Additionally, the amplitude can be made larger by such a configuration as shown in Fig. 13, in which a transformer 50 is provided in the latter portion of RTD. Transformer 50 can be minutely formed by using such semiconductor technology as explained in the above mentioned cross wiring.

As aforementioned, in this invention, diode bridge 30 and RTD which operates as a strobe pulse generator are formed on the same substrate in monolithic manner, and further, the conductive state or non-conductive state of diode bridge 30 is controlled by the strobe pulse from RTD.

In this invention, RTD can output a high frequency strobe pulse and hence a large and high speed power transformer used in the conventional apparatus for driving SRD, is unnecessary. As a result, in this invention, total size of the sampling head can be reduced.

Further, since the large and high speed power transformer is not used in this invention, the amount of noises which enter through the transformer into a signal transmission line, can be reduced.

In this invention, the impurity concentration of the layer on the positive pole side of RTD is lowered, and is made asymmetrical with respect to the impurity concentration of the layer on the opposite side of RTD. As a result, the depletion layer is expanded and the amplitude is increased. Further, a parasitic capacitance can be reduced. Therefore, by the invention, both speed up and the large amplitude are attained at the same time.

When diode bridge 30 is driven by the strobe pulse, the maximum voltage (V_{M}) of the input signal which can pass through diode bridge 30 is given by the following equation:${\text{V}}_{\text{M}} {\text{= V}}_{\text{S}} {\text{- V}}_{\text{FS}}$
where V_{S} is an amplitude voltage of the strobe pulse, and V_{FS} is a total ON voltage of a pair of the Schottky diodes connected in series in diode bridge 30.

In this invention, since the amplitude V_{S} of the strobe pulse is large, the large amplitude input signal can pass through the diode bridge 30, and therefore, a sampling head having a wide dynamic range is obtained.

Further, in this invention, the four element mixed crystal of InGaAlAs is used for the diode bridge, and the ON voltage (V_{F}) of the diode can be controlled by changing the mixture ratio of the four element mixed crystal. As a result, it is possible to expand the dynamic range by lowering the above ON voltage V_{F}.

## Claims

1. A sampling head having an input terminal (20) to which a sampling signal is applied, a diode bridge (30) to which said sampling signal is applied, and a strobe pulse generator by which the gate time of said diode bridge (30) is controlled,
characterized in that
said diode bridge (30) and a resonance tunnel barrier diode (3) which is used as said strobe pulse generator are formed on the same substrate in monolithic manner, and
a transmission line (S1 - S6) between said input terminal (20) and said diode bridge (30) and a further transmission line (S8) for holding the sampling signal are formed by coplanar wave guides and transmission lines (S7, S9 - S11) between said resonance tunnel barrier diode (3) and said diode bridge (3) are formed by coplanar stripping lines, so as to avoid mismatching therebetween.

2. The sampling head of claim 1, wherein the impurity concentration of a layer formed on a positive pole side of said resonance tunnel barrier diode (3) is lowered and is made asymmetrical with respect to the impurity concentration of a layer formed on an opposite side of said resonance tunnel barrier diode (3).

3. The sampling head of claim 1, wherein said diode bridge (30) is constituted by Schottky diodes made of a four element mixed crystal of InGaAlAs, and formed on said substrate of InP together with said resonance tunnel barrier diode (3).

4. The sampling head of claim 1, wherein said resonance tunnel barrier diode (3) is driven by a pulse having sufficiently short time width in comparison with the time when avalanche breakdown occurs.

## Patentansprüche

1. Abtastkopf mit einem Eingangsanschluß (20), an dem ein Abtastsignal liegt, einer Diodenbrücke (30), an der das Abtastsignal angelegt ist, und einem Strobe- bzw. Abtastimpulsgenerator, durch den die Gatterzeit der Diodenbrücke (30) gesteuert ist,
dadurch gekennzeichnet, daß
die Diodenbrücke (30) und eine Resonanz-Tunnel-Sperrschichtdiode (3), die als der Strobe- bzw. Abtastimpulsgenerator verwendet ist, auf dem gleichen Substrat in monolithischer Weise gebildet sind, und
eine Übertragungsleitung (S1 bis S6) zwischen dem Eingangsanschluß (20) und der Diodenbrücke (30) und eine weitere Übertragungsleitung (S8) zum Halten des Abtastsignales durch koplanare Wellenleiter gebildet sind, und Übertragungsleitungen (S7, S9 bis S11) zwischen der Resonanz-Tunnel-Sperrschichtdiode (3) und der Diodenbrücke (3) durch koplanare Streifenleitungen gebildet sind, um eine Fehlanpassung dazwischen zu vermeiden.

2. Abtastkopf nach Anspruch 1, bei dem die Fremdstoffkonzentration einer Schicht, die auf der Seite des positiven Poles der Resonanz-Tunnel-Sperrschichtdiode (3) gebildet ist, abgesenkt ist und asymmetrisch gemacht ist bezüglich der Fremdstoffkonzentration einer Schicht, die auf einer entgegengesetzten Seite der Resonanz-Tunnel-Sperrschichtdiode (3) gebildet ist.

3. Abtastkopf nach Anspruch 1, bei dem die Diodenbrücke (30) aus Schottky-Dioden hergestellt ist, die aus einem Vierelement-Mischkristall aus InGaAlAs gebildet sind, und auf dem Substrat von InP zusammen mit der Resonanz-Tunnel-Sperrschichtdiode (3) ausgebildet ist.

4. Abtastkopf nach Anspruch 1, bei dem die Resonanz-Tunnel-Sperrschichtdiode (3) durch einen Impuls angesteuert ist, der eine ausreichend kurze Zeitdauer im Vergleich mit der Zeit hat, in der ein Lawinendurchbruch auftritt.

## Revendications

1. Une tête d'échantillonnage comportant une borne d'entrée (20) à laquelle est appliqué un signal d'échantillonnage, un pont à diodes (30) auquel ledit signal d'échantillonnage est appliqué, et un générateur d'impulsions de sélection par lequel la durée de passage dudit pont à diodes (30) est commandée,
caractérisée en ce que
ledit pont à diodes (30) et une diode de barrage à effet tunnel de résonance (3) qui est utilisée comme générateur d'impulsions de sélection sont formés sur le même substrat de manière monolithique, et
une ligne de transmission (S1 - S6) entre ladite borne d'entrée(20) et ledit pont à diodes (30) et une autre ligne de transmission (S8) pour maintenir le signal d'échantillonnage sont formées par des guides d'ondes coplanaires, et des lignes de transmission (S7, S9 - S11) entre ladite diode de barrage à effet tunnel de résonance (3) et ledit pont à diodes (30) sont formées par des lignes en bandes coplanaires, de manière à éviter une désadaptation entre elles.

2. La tête d'échantillonnage de la Revendication 1, dans laquelle la concentration d'impuretés d'une couche formée sur le côté du pôle positif de ladite diode de barrage à effet tunnel de résonance (3) est abaissée et est rendue asymétrique par rapport à la concentration d'impuretés d'une couche formée du côté opposé de ladite diode de barrage à effet tunnel de résonance (3).

3. La tête d'échantillonnage de la Revendication 1, dans laquelle ledit pont à diodes (30) est constitué par des diodes Schottky constituées d 'un cristal mélangé à quatre éléments de InGaAlAs, et formées sur ledit substrat de InP conjointement avec ladite diode de barrage à effet tunnel de résonance (3).

4. La tête d'échantillonage de la Revendication 1, dans laquelle ladite diode de barrage à effet tunnel de résonance (3) est commandée par une impulsion ayant une largeur en temps suffisamment courte par comparaison avec l'instant auquel le claquage par avalanche se produit.
